# EUROPÄISCHE PATENTSCHRIFT

(11) **EP 0 478 993 B1**
(45) Veröffentlichungstag und Bekanntmachung des Hinweises auf die Patenterteilung: **25.10.1995**
(21) Anmeldenummer: 91115230.4
(22) Anmeldetag: 10.09.1991
(51) Int. Cl.: D01H 1/16, H05K 7/20

(54) **Verfahren und Vorrichtung zum Kühlen der Antriebsaggregate einer Ringspinn- oder Zwirnmaschine**
Procedure and device for cooling the driving units of a ring spinning or twisting machine
Procédé et dispositif pour refroidir les équipements moteur d'un métier à filer à anneaux ou d'un métier à retordre

(30) Priorität: 02.10.1990 CH 3169/90
(43) Veröffentlichungstag der Anmeldung: 08.04.1992
(73) Patentinhaber: MASCHINENFABRIK RIETER AG, CH-8406 Winterthur (CH)
(72) Erfinder: Wolf, Horst, CH-8185 Winkel b. Bülach (CH); Schwengeler, Peter, CH-8408 Winterthur (CH)

(56) Entgegenhaltungen:
- EP-A- 0 345 667
- CH-A- 674 993
- DE-A- 3 434 724
- DE-A- 3 517 149
- IBM TECHNICAL DISCLOSURE BULLETIN. Bd. 32, Nr. 6B, November 1989, NEW YORK US Seiten 417 - 419; 'Open-loop cooling system for computers in a hostile environment'
- SIEMENS ENERGY & AUTOMATION. Bd. 9, Nr. 2, Juli 1989, BERLIN DE Seiten 3 - 5; STEPHAN KRAMM: 'Textiles: Variable-Speed Drives ensure top quality'
- NEW ELECTRONICS.INCORPORATING ELECTRONICS TODAY.Bd. 17, Nr. 14, Juli 1984, LONDON GB Seiten 47 - 49; KEITH REYNOLDS: 'Cooling Systems in 19-Inch cabinets'

## Beschreibung

Die vorliegende Erfindung betrifft ein Verfahren zur Kühlung der Antriebsaggregate, insbesondere auch deren Leistungselektronik einer Ringspinn- oder Zwirnmaschine und eine entsprechend ausgebildete Maschine zur Durchführung des Verfahrens.

Ringspinn- oder Zwirnmaschinen befinden sich in stetiger Weiterentwicklung. Insbesondere soll die Qualität der Erzeugnisse gesteigert und die Produktivität der Maschinen durch Verringerung des Wartungsaufwands und durch Rationalisierung der umgebenden technischen Infrastruktur erhöht werden, womit die Kosten des hergestellten Guts sinken.

Maschinen der genannten Art werden vermehrt mit Synchron- und/oder Asynchronmotoren ausgestattet, wobei die Motoren ihrerseits durch Frequenzumrichter angesteuert sind. Die Spindelwellen und die Streckwerkzylinder verfügen damit je über einen eigenen Antrieb, was insbesondere erlaubt, die Qualität des Spinn- oder Zwirnprozesses zu verbessern und die Produktionsgeschwindigkeit zu steigern.

Zur Kühlung eines Antriebsaggregates einer Spinnmaschine wurde beispielsweise nach dem US-Patent 4 699 208 vorgeschlagen, aus dem Spinnsaal durch ein Gebläse in der Spinnmaschine Luft anzusaugen und über einen Wärmetauscher einer elektrischen Komponente zu leiten. Die am Wärmetauscher aufgeheizte Luft wird wieder in den Spinnsaal zurückgeleitet, wodurch sich die Saalluft unerwünscht aufheizen kann. Ausserdem werden durch das Gebläse angesaugte Verunreinigungen dadurch grossflächig im Spinnsaal verteilt, wodurch der Wartungsaufwand steigt oder um so wirksamere Absaugeinrichtungen nötig werden.

Ein ähnliches Verfahren wird in der schweizerischen Patentschrift CH-A5-674993 beschrieben. Darin wird Luft zur Kühlung von Antriebsmotoren aus dem Spinnsaal angesaugt und durch einen Abluftkanal im Fundament des Maschinengestells abgeführt. Aus der Schrift ist kein Hinweis zu entnehmen, wie die Abluft aus dem Spinnsaal gelangt.

Als Beispiel einer einschlägigen Publiktion aus einem anderen Fachgebiet sei das IBM Technical Disclosure Bulletin, Band 32, Nr. 68, Seiten 417 - 419 genannt. In dem Artikel wird vorgeschlagen, Luft zur Kühlung von Computern über verschiedene Filter den Komponenten des Computers zuzuleiten. Die Abluft wird, da es sich um einen offenen Kühlkreis handelt, wieder in die Umgebung des Computers abgeleitet.

Es ist Aufgabe der vorliegenden Erfindung, ein Verfahren zum Kühlen von Antriebsaggregaten zu schaffen, bei dem die direkte Entnahme bzw. Rückgabe von Kühlluft aus bzw. in den Spinnsaal vermieden wird, womit die Nachteile der Spinnsaalaufheizung und der Verwirbelung von Faserflug und Staub durch die Umwälzung der Kühlluft eliminiert werden. Diese Aufgabe wird durch die Merkmale gemäss Anspruch 1 und Anspruch 7 gelöst.

Durch die in einen Abluftstrom zusammengefasste Abluft steht ein vorgereinigter Luftstrom zur Verfügung, welcher als Kühlmedium für Wärmetauscher der Leistungselektronik, d.h. unter anderem der Frequenzumrichter, Verwendung finden kann. Dabei verhindert der im Bereich des Wärmetauschers beschleunigt fliessende Luftstrom, dass der nicht im Filter hängengebliebene Staub sich auf dem Wärmetauscher ablagert, den Wärmeübergang stört und die Gefahr schafft, dass Luftkanäle verstopfen.

Weiter kann der Abluftstrom über eine Abluftöffnung von der Maschine abgeführt und direkt in die Belüftungs- oder in die Klimatisierungseinrichtung des Spinnsaals geführt werden. Dies hat zur Folge, dass die aus der Maschine abgegebene Abluft nicht mehr Luftströmungen im Spinnsaal erzeugt, welche den dort vorhandenen Flug aufwirbeln und zu einem Niederschlag auf der Maschine führen, und dass wärmebeladene Luft direkt in die Klimatisierungseinrichtung des Spinnsaals gelangt, wodurch die Luft im Spinnsaal kühler bleibt. So wird die Klimatisierungseinrichtung entlastet; die Luft im Spinnsaal muss weniger häufig umgewälzt werden; weiter können die Wärmetauscher der Klimatisierungseinrichtung wegen des bessern Wärmeübergangs durch die erhöhte Temperatur im Abluftstrom kleiner dimensioniert werden.

Es ergibt sich, dass auch der Wartungsaufwand verringert, und, über die gestellte Aufgabe hinaus, die umgebende technische Infrastruktur entlastet werden kann.

Ein bevorzugtes Ausführungsbeispiel nach dem Verfahren gemäss Anspruch 2 besitzt die Merkmale von Anspruch 7. Die übrigen Unteransprüche betreffen vorteilhafte Weiterbildungen der Erfindung.

Im Fall der Verwendung eines Abluftstroms, welcher nur aus den Streckwerken stammenden Flug, also nur Fasern mit sich trägt, kann der ausgefilterte Flug als Rohmaterial wiedergewonnen werden, was zusätzlich die Infrastruktur entlastet und eine bessere Verwertung des Rohstoffs erlaubt.

Nachstehend wird ein bevorzugtes Ausführungsbeispiel anhand der Figuren näher beschrieben. Es zeigt:
- Fig. 1: rein schematisch einen Teil einer Ringspinn- oder Zwirnmaschine gemäss der vorliegenden Erfindung; und
- Fig. 2a,2b: schematisch den entlang der Schnittebenen A und B aufgeschnittenen Kopf der Maschine von Fig. 1, und
- Fig. 3: Teile der Abluftführung vom Sammelkanal der Spinnmaschine bis zum ersten Gebläse vor Eintritt in den Kühlluftkanal im Bereich der Schnittebenen A und B.

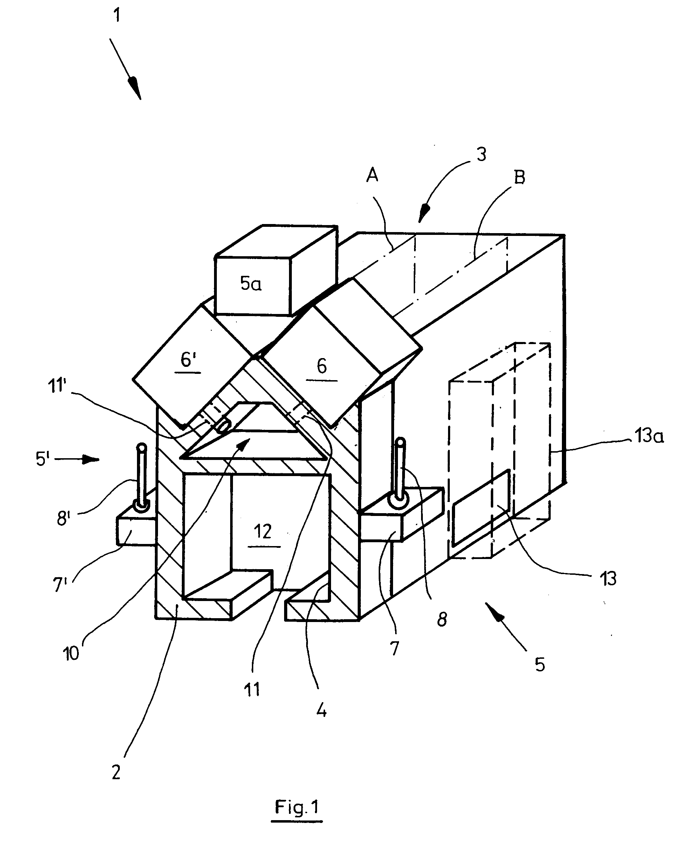

Fig. 1 zeigt schematisch einen Endbereich 3 einer Ringspinn- oder Zwirnmaschine 1; dargestellt ist die senkrecht zur Maschinenlängsachse verlaufende Schnittfläche 2 sowie ein die Antriebsaggregate enthaltender Endbereich 3. In der Schnittfläche liegen ein Maschinenrahmen 4 und daran angeordnete, einander gegenüberliegende Spinneinheiten 5,5', welchen über Luntenhalter 5a Lunte oder zu zwirnender Faden zugeführt wird. Die Spinneinheiten 5,5' weisen je ein Streckwerk 6,6', eine Spindelwellenlagerung 7,7' und eine Spindelwelle 8,8' auf. Ebenfalls zu jeder Spinneinheit 5,5' gehörende Fadenführungseinrichtungen mit je einem Ring, einem daran laufenden Läufer und einem Ballonbegrenzer sind zur Entlastung der Figur weggelassen.

Im Rahmen 4 verläuft ein zentraler Sammelkanal 10 der Abluftführung längs durch die Maschine 1, welcher durch Oeffnungen 11,11' mit den Streckwerken 6,6' in Verbindung steht. Ein unterhalb des Kanals 10 im Bereich 12 angeordneter Riementrieb für die Spindelwellen 8,8' ist zur Entlastung der Figur ebenfalls weggelassen.

Im Endbereich 3 sind die Antriebsmotoren für den Riementrieb der Spindelwellen, für die Streckwerke und das Abluftgebläse angeordnet. Weiter befinden sich im Endbereich 3 die Frequenzumrichter aufweisende Leistungselektronik 16 zur Steuerung von Antriebsmotoren sowie ein Wärmetauscher 30 dieser Leistungselektronik. Die über den Sammelkanal 10 geförderte Abluft wird über eine Oeffnung 13 von der Maschine 1 nach aussen abgegeben; ein Entlüftungskanal 13a der Klimatisierungseinrichtung des Spinnsaals ist gestrichelt angedeutet.

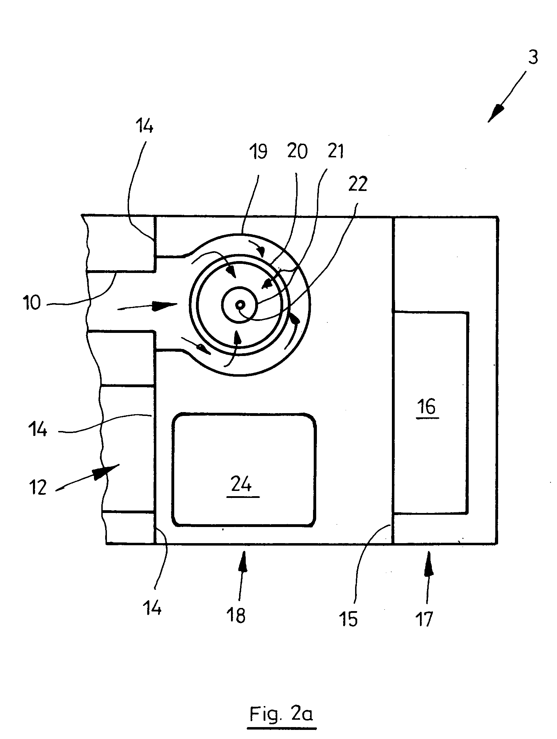

Fig. 2a zeigt schematisch den entlang der Schnittebene A (Fig. 1) längs aufgeschnittenen Endbereich 3 der Maschine 1. Eine erste Zwischenwand 14 trennt den Endbereich 3 von dem die Spinneinheiten 5,5' aufweisenden Teil der Maschine 1. Eine zweite Zwischenwand 15 trennt einen die Leistungselektronik 16 enthaltenen Bereich 17 von einem Bereich 18 mit der Abluftführung.

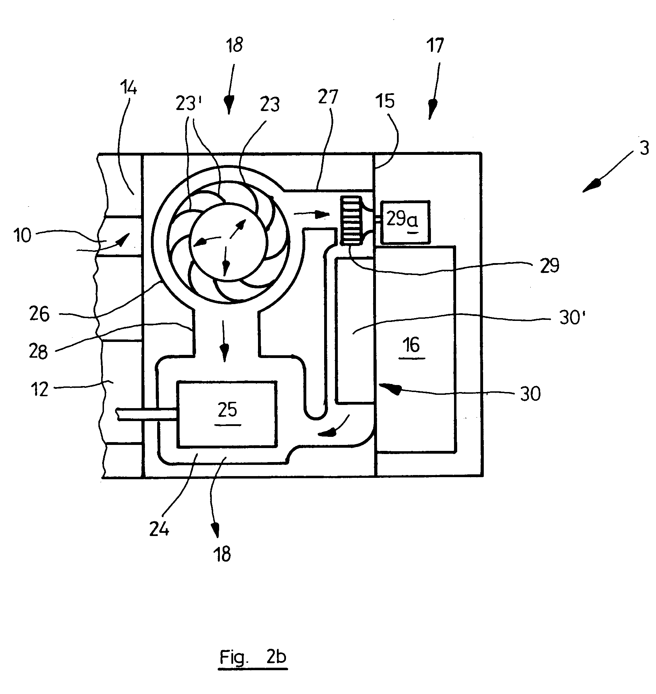

Der Sammelkanal 10 mündet an der Zwischenwand 14 in einen horizontal zum Endbereich 3 verlaufenden Abschnitt 19 mit einem Trommelfilter 20 für die aus dem Streckwerk abgeführten Fasern. Im Trommelfilter 20 ist, von der Abluft umströmt, ein Motor 21 mit einer Antriebswelle 22 für ein Abluftgebläse 23 (Fig. 2b) angeordnet. Unter dem Abschnitt 19 ist ein Raum 24 für weitere Maschinenaggregate wie z.B. den Antriebsmotor 25 (Fig. 2b) für die Spindelwellen 8,8' vorgesehen.

Fig. 2b zeigt schematisch den entlang der Schnittebene B (Fig. 1) aufgeschnittenen Endbereich 3. Dargestellt ist das Gebläse 23 in einem an den Abschnitt 19 (Fig. 2a) anschliessenden Abschnitt 26, von welchem ein als Kühlluftkanal 27 ausgebildeter Abluftkanal sowie ein weiterer Kanalabschnitt 28 wegführen.

Im Kühlluftkanal 27 sind ein Gebläse 29 mit einem Antriebsmotor 29a zur Beschleunigung des Kühlluftstroms sowie Kühlrippen 30' des Wärmetauschers 30 der Leistungselektronik 16 angeordnet. Nach dem Wärmetauscher 30 mündet der Kühlluftkanal 27 in den Raum 24.

Der Abluftkanal 28 mündet ebenfalls in den Raum 24. Von dort kann die Luft durch die Oeffnung 13 nach Fig. 1 nach aussen abgeführt werden.

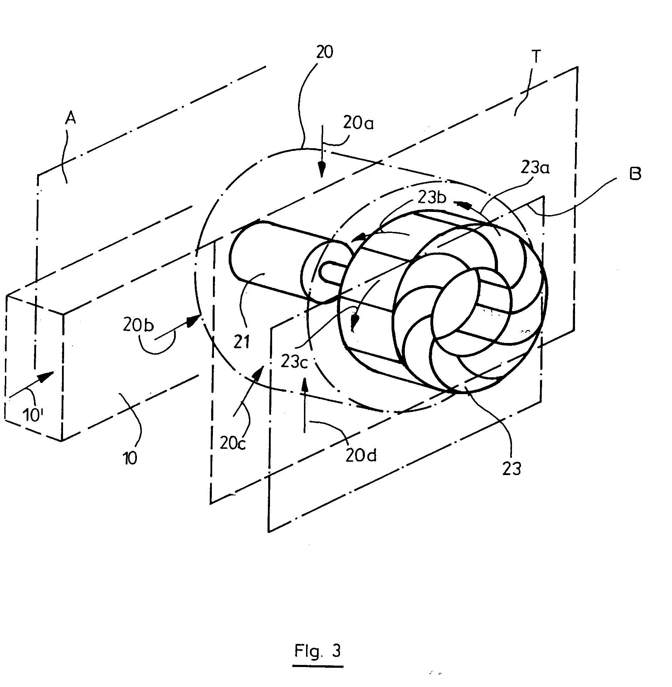

In Fig. 3 ist zur Veranschaulichung der räumlichen Situation in perspektivischer schematischer Darstellung der Sammelkanal 10 gezeigt, von dem aus gemäss Pfeil 10' die Abluft radial gemäss Pfeilen 20a,20b,20c,20d in einen Trommelfilter 20 eintritt, der einen Antriebsmotor 21 für ein Gebläse 23 umgibt. Beim Durchtritt durch den Trommelfilter 20 wird die Abluft weitgehend gereinigt. Sie strömt dann durch eine Oeffnung in einer Trennwand T horizontal und axial in das Gebläse 23, welches sie in Richtung der Pfeile 23a,23b,23c verlässt, um von dort in die Kühlluftkanäle 27 und 28 gemäss Fig. 2b zu gelangen. Während der Sammelkanal 10, der Trommelfilter 20 und der Motor 21 in der Schnittebene A liegen, befindet sich das Gebläse 23 in der Schnittebene B.

Im Raum 24 ist der Motor 25 umströmt von der Abluft angeordnet.

Ueber die Oeffnungen 11,11' wird Luft durch die Streckwerke 6,6'angesogen, mit den dort anfallenden Fasern beladen und als Abluft über den Sammelkanal 10 in den Abschnitt 19 (Fig. 2a) mit dem Trommelfilter 20 gefördert. In der Folge strömt die Abluft entsprechend der eingezeichneten Pfeilrichtung in das Innere des Trommelfilters 20 und wird dadurch von den Fasern befreit.

Die sich beim Trommelfilter 20 sammelnden Fasern können als Rohmaterial dem Spinnprozess wieder zugeführt werden, was die Entsorgung entlastet und eine verbesserte Nutzung des Rohmaterials gestattet.

Die weitgehend gereinigte Abluft umspült den Motor 21, führt dessen Wärme ab, strömt axial aus dem Trommelfilter 20 hinaus ins Innere des Gebläses 23 (Fig. 2b), und radial durch die Gebläseschaufeln 23' hindurch in den Abschnitt 26. Von dort aus strömen ca. ein Viertel der Abluft durch den Kühlluftkanal 27 und ca. drei Viertel durch den Abschnitt 28 direkt in den Raum 24.

Im Kühlluftkanal 27 wird die Abluft durch das Gebläse 29 beschleunigt und an den Kühlrippen 30' des Wärmetauschers 30 vorbeigeführt. Durch den schnellen Luftstrom wird sichergestellt, dass sich der noch mitgeführte Faserstaub nicht an den Kühlrippen absetzen und so den Wärmeübergang stören kann.

Da das Gebläse 29 nur einen Teil der insgesamt vorverdichteten Abluft verarbeiten muss, ergibt sich, dass es mit vergleichsweise geringer Leistung gefahren werden kann, somit für die Kühlung der Leistungselektronik 16 weniger Energie eingesetzt werden muss, als dies bei konventionellen Ringspinn- oder Zwirnmaschinen der Fall ist.

Die Abluftströme aus den Kanälen 27 und 28 treffen sich im Raum 24, wo sie den Hauptantriebsmotor 25 umspülen und dessen Abwärme abführen.

Hinter dem Raum 24 gelangt die aufgeheizte Abluft über die Abluftöffnung 13 (Fig. 1) und den Kanal 13a beispielsweise in die Klimatisierungseinrichtung des Spinnsaals.

Damit wird zum einen die Abwärme nicht mehr an die Saalluft abgegeben und weiter der in der Saalluft vorhandene Flug nicht mehr durch den erheblichen Abluftstrom von über 5000m³/h aufgewirbelt. Es folgt, dass die Klimatisierungseinrichtung des Spinnsaals entlastet und die Verschmutzung verringert ist.

Bei einem nicht dargestellten Ausführungsbeispiel wird der Abluftstrom im Kanal 27 durch eine Verengung beschleunigt, so dass ein Gebläse 29 entfällt.

Bei einem weitern nicht dargestellten Ausführungsbeispiel werden die Streckzylinder antreibende Motoren ebenfalls durch die Abluft der Maschine 1 gekühlt.

Bei einem andern nicht dargestellten Ausführungsbeispiel wird die beschleunigt fliessende Luft aus dem Kanal 27 auf vorbestimmte Bereiche im Raum 24 gelenkt, wo sie sensible Bereiche reinigt und/oder aus besonders zu kühlenden Bereichen Wärme abführt.

## Patentansprüche

1. Verfahren zum Kühlen von Antriebsaggregaten mit einer Leistungselektronik einer Ringspinn- oder Zwirnmaschine in einem Spinnsaal, bei dem Luft gegen einen Wärmetauscher (30) der Leistungselektronik (16) geführt, vor diesem beschleunigt, an diesem erwärmt und hinter diesem über eine Abluftöffnung (13) nach aussen abgegeben wird,
dadurch gekennzeichnet, dass die Luft ein Teilstrom der Abluft der Maschine ist, der vom Hauptstrom der Abluft abgezweigt und ohne Erzeugung von Luftströmungen im Spinnsaal aus diesem abgeführt wird.

2. Verfahren nach Anspruch 1, dadurch gekennzeichnet, dass die Abluft vor dem Wärmetauscher (30) aufbereitet, insbesondere von Flug mindestens grobgereinigt wird.

3. Verfahren nach Anspruch 1, dadurch gekennzeichnet, dass von den Spinn- oder Zwirnstellen (5,5') Luft abgesaugt und die entsprechenden Luftströme als Abluft der Maschine (1) zusammengefasst werden.

4. Verfahren nach einem der vorstehenden Ansprüche, dadurch gekennzeichnet, dass die Abluft aus den Streckwerken (6,6') der Spinnstellen (5,5') stammt

5. Verfahren nach einem der Ansprüche 1 bis 4, dadurch gekennzeichnet, dass der Teilstrom von Abluft nach dem Wärmetauscher (30) dem Hauptabluftstrom wieder beigemischt wird.

6. Verfahren nach Anspruch 5, dadurch gekennzeichnet, dass der Teilstrom zusammen mit dem Hauptstrom zur Kühlung weiterer hinter dem Wärmetauscher vorgesehener zu kühlender Komponenten (25) verwendet wird.

7. Verfahren nach Anspruch 6, dadurch gekennzeichnet, dass der Teilstrom zur Kühlung vorbestimmter Bereiche der weiteren Maschinenaggregate (25) verwendet wird.

8. Ringspinn- oder Zwirnmaschine zur Durchführung des Verfahrens nach einem der Ansprüche 1 bis 7, mit einem Rahmen (4), mit darin liegenden Spinnstellen (5,5'), bestehend aus je einem Streckwerk (6,6'), einer Spindelwelle (8,8') und einer dazugehörenden Fadenführungseinrichtung, mit einer Abluftführung (10) und mit einem Antrieb (25) sowie einer diesen steuernden, einen Wärmetauscher (30) aufweisenden Leistungselektronik (16), dadurch gekennzeichnet, dass die Abluftführung in einer Abluftöffnung (13) an der Peripherie der Maschine (1) endet und einen Abluftkanal (27) für mindestens einen Teilstrom der Abluft aufweist, in welchem Mittel (29) zum Beschleunigen der Abluft und der Wärmetauscher (30) der Leistungselektronik (16) angeordnet sind, und dass zur Weiterführung der Abluft eine Klimatisierungseinrichtung vorgesehen ist.

9. Ringspinn- oder Zwirnmaschine nach Anspruch 8, dadurch gekennzeichnet, dass vor dem Abluftkanal (27) Mittel zum Aufbereiten der durch diesen fliessenden Abluft mit vorzugsweise einem Trommelfilter (20) zum Entfernen von Flug vorgesehen sind.

10. Ringspinn- oder Zwirnmaschine nach Anspruch 8 oder 9, dadurch gekennzeichnet, dass die Mittel zum Beschleunigen der Abluft ein Gebläse, vorzugsweise ein Radialgebläse (23), aufweisen.

11. Ringspinn- oder Zwirnmaschine nach einem der Ansprüche 8 bis 10, dadurch gekennzeichnet, dass der einen Teilstrom führende Abluftkanal (27) wieder in den Hauptstrom der Abluftführung (24) mündet.

## Claims

1. A method for cooling the driving units with power electronics of a ring spinning or twisting machine in a spinning room, in which the air is guided towards a heat exchanger (30) of the power electronics (16), is accelerated before it, is heated on it and discharged behind it to the outside through an outgoing air opening (13), characterized in that the air is a partial stream of the outgoing air of the machine, which partial stream is branched from the machine, which partial stream is branched from the main stream of the outgoing air and is discharged therefrom without producing any air streams in the spinning room.

2. A method as claimed in claim 1, characterized in that the outgoing air is prepared before the heat exchanger (30), i.e. it is cleaned at least roughly from fibre fly, in particular.

3. A method as claimed in claim 1, characterized in that air is sucked off from the spinning or twisting positions (5, 5') and the respective air streams are combined as outgoing air of the machine (1).

4. A method as claimed in one of the preceding claims, characterized in that the outgoing air originates from the drafting arrangements (6, 6') of the spinning positions (5, 5').

5. A method as claimed in one of the claims 1 to 4, characterized in that the partial stream of outgoing air is mixed with the main stream of outgoing air again after the heat exchanger (30).

6. A method as claimed in claim 5, characterized in that the partial stream together with the main stream is used for cooling further components (25) to be cooled behind the heat exchanger.

7. A method as claimed in claim 6, characterized in that the partial stream is used for cooling predetermined zones of the other machine units (25).

8. A ring spinning or twisting machine for carrying out the method as claimed in one of the claims 1 to 7, with a frame (4) with spinning positions (5, 5') disposed therein, each consisting of a drafting arrangement (6, 6'), a spindle shaft (8, 8') and a thread guide device associated therewith, with an outgoing air guiding means (10) and with a drive (25) as well as power electronics controlling said drive and having a heat exchanger (30), characterized in that the outgoing air guiding means ends in an outgoing air opening (13) at the periphery of the machine (1) and comprises an outgoing air duct (27) for at least one partial stream of the outgoing air, in which means (29) for accelerating the outgoing air and the heat exchanger (30) of the power electronics (16) are arranged, and that an air-conditioning device is provided for further guiding the outgoing air.

9. A ring spinning or twisting machine as claimed in claim 8, characterized in that before the outgoing air duct (27) means are provided for preparing the outgoing air flowing through it with preferably one drum filter (20) for removing fibre fly.

10. A ring spinning or twisting machine as claimed in claim 8 or 9, characterized in that the means for accelerating the outgoing air are provided with a blower unit, preferably a radial flow compressor (23).

11. A ring spinning or twisting machine as claimed in one of the claims 8 to 10, characterized in that the outgoing air duct (27) carrying a partial stream opens out again into the main stream of the outgoing air guiding means (24).

## Revendications

1. Procédé pour refroidir des agrégats d'entraînement avec une électronique de puissance d'une machine à filer à anneaux ou d'une machine à retordre dans une salle de filage, dans lequel de l'air, dirigé contre un échangeur de chaleur (30) de l'électronique de puissance (16), est accéléré avant celui-ci, est réchauffé par celui-ci, et est expulsé vers l'extérieur par une ouverture d'air extrait (13) située derrière celui-ci,
caractérisé par le fait que
l'air est un courant partiel de l'air extrait de la machine, lequel est dévié du courant principal de l'air extrait, et est évacué hors de la salle de filage sans produire des courants d air dans celle-ci.

2. Procédé selon revendication 1,
caractérisé par le fait que
l'air extrait est traité avant l'échangeur de chaleur (30), particulièrement, il est au moins libéré grossièrement des fibres volantes.

3. Procédé selon revendication 1,
caractérisé par le fait que
de l'air est aspiré depuis les postes de filage ou de retordage (5, 5') et les courants d'air correspondants sont rassemblés comme air extrait de la machine (1).

4. Procédé selon l'une des revendications précédentes,
caractérisé par le fait que
l'air extrait provient des trains d'étirage (6, 6') des postes de filage (5, 5').

5. Procédé selon une des revendications 1 a 4,
caractérisé par le fait que
le courant partiel de l'air extrait est a nouveau mélangé avec le courant principal d'air extrait, après l'échangeur de chaleur (30).

6. Procédé selon revendication 5,
caractérisé par le fait que
le courant partiel, conjointement avec le courant principal, est utilisé pour le refroidissement d'autres composants (25) devant être refroidis, et prévus après l'échangeur de chaleur.

7. Procédé selon revendication 6,
caractérisé par le fait que
le courant partiel est utilisé pour le refroidissement de zones prédéterminées des autres agrégats de machine (25).

8. Machine à filer à anneaux ou machine à retordre utilisée pour la réalisation du procédé selon une des revendications 1 à 7, avec un cadre (4), avec des postes de filage (5, 5') situés dans celui-ci et constitués chacun par un train d'étirage (6, 6'), un arbre de broche (8, 8') et un arrangement de guidage de fil lui appartenant, avec une conduite d'air extrait (10) et avec un entraînement (25), ainsi qu'une électronique de puissance (16) asservissant celui-ci et possédant un échangeur de chaleur (30),
caractérisée par le fait que
la conduite d'air extrait se termine par une ouverture d'air extrait (13) dans la périphérie de la machine (1), et possède un canal d'air extrait (27) pour au moins un courant partiel de l'air extrait, dans lequel sont disposés, des moyens (29) pour accélérer l'air extrait et l'échangeur de chaleur (30) de l'électronique de puissance (16), et qu'un arrangement de climatisation est prévu pour la gestion ultérieure de l'air extrait.

9. Machine a filer à anneaux ou machine à retordre selon revendication 8,
caractérisée par le fait que,
pour le traitement de l'air extrait s'écoulant a travers le canal d'air extrait (27), des moyens sont prévus avant celui-ci, avec de préférence un filtre tambour (20) servant a éloigner les fibres volantes.

10. Machine a filer à anneax ou machine à retordre selon revendication 8 ou 9,
caractérisée par le fait que
les moyens utilisés pour accélérer l'air extrait possèdent un ventilateur, de préférence un ventilateur radial (23).

11. Machine a filer à anneaux ou machine à retordre selon une des revendications 8 a 10 ,
caractérisée par le fait que
le canal d'air extrait (27) guidant un courant partiel, débouche à nouveau dans le courant principal de la conduite d'air extrait (24).
